# EUROPÄISCHE PATENTANMELDUNG

(11) **EP 4 141 922 A1**
(43) Veröffentlichungstag der Anmeldung: **01.03.2023**
(21) Anmeldenummer: 21193194.4
(22) Anmeldetag: 26.08.2021
(51) Int. Cl.: H01L 23/373, H01L 25/07, H05K 3/28

(54) **LEISTUNGSELEKTRONISCHE BAUGRUPPE**

(71) Anmelder: Siemens Aktiengesellschaft, 80333 München (DE)
(72) Erfinder: Heimann, Matthias, 14469 Potsdam (DE); Lorz, Roland, 91341 Röttenbach (DE); Müller, Bernd, 16259 Falkenberg (DE); Radüge, Christian, 90425 Nürnberg (DE); Stegmeier, Stefan, 81825 München (DE); Strogies, Jörg, 14163 Berlin (DE)

(57) **Zusammenfassung**

Die Erfindung betrifft eine leistungselektronische Baugruppe (100) und ein Verfahren zum Herstellen eines Halbzeugs für eine leistungselektronischen Baugruppe (100). Um eine verbesserte leistungselektronische Baugruppe (100) anzugeben wird vorgeschlagen, dass die Baugruppe (100), ein Substrat (20) mit einer Metallisierung (30), die durch Zwischenräume (40) voneinander getrennte erste und zweite Strukturen (35, 36) ausbildet und eine Dicke (D30) von zumindest 300 µm aufweist, wobei auf die ersten Strukturen (35) ein Leistungshalbleiter (50) aufgebracht ist. Bezüglich der Zwischenräume (40) ist zumindest abschnittsweise ein elektrischer Isolator (42) mit einer Wärmeleitfähigkeit von zumindest 50 W/mK so angeordnet, dass die an den jeweiligen Zwischenraum (40) angrenzenden Strukturen (35, 36) durch den Isolator (42) thermisch verbunden sind.

## Beschreibung

Die Erfindung betrifft eine leistungselektronische Baugruppe. Die Erfindung betrifft weiterhin Verfahren zum Herstellen eines Halbzeugs für die leistungselektronischen Baugruppe.

Eine derartige leistungselektronische Baugruppe kommt beispielsweise in Leistungsmodulen für Umrichter zum Einsatz. Anwendungen können hierbei im Bereich der elektrischen Antriebstechnik, der Spannungswandlung oder der Energietechnik liegen.

Bei heutigen Schaltungsträgern für leistungselektronische Baugruppen befinden sich die schaltenden Bauelemente (IGBTs, MOSFETS, ...) auf metallischen Leiterbahnen, welche einerseits die Aufgabe haben, den Strom zu leiten, aber auch die Abwärme des Halbleiters aufzuspreizen und zu einem Kühler zu leiten. Je dicker die Kupferlagen, desto effizienter findet dabei die laterale Wärmeverteilung statt. Schaltungen weisen im Betrieb meist hohe Temperaturunterschiede auf, d.h. heiße Regionen bzw. Strukturen nahe dem Halbleiterchip und kühlere Regionen bzw. Strukturen, welche vom Chip meist weiter entfernt sind bzw. thermisch getrennt sind (z.B. Gatekontakte, Emittersense, Shuntkontakte, ...). Diese Temperaturunterschiede führen dazu, dass heute Bodenplatten zur Temperaturverteilung eingesetzt werden oder auch der Kühler selbst aufwendiger gestaltet werden muss.

Der Erfindung liegt die Aufgabe zugrunde, eine verbesserte leistungselektronische Baugruppe anzugeben.

Diese Aufgabe wird durch eine leistungselektronische Baugruppe mit den im Anspruch 1 angegebenen Merkmalen gelöst. Die leistungselektronische Baugruppe umfasst dabei ein Substrat mit einer Metallisierung. Die Metallisierung ist strukturiert ausgeführt. Die Metallisierung weist zur Strukturierung Zwischenräume auf, durch die sich voneinander getrennte erste und zweite Strukturen ausbilden. Die Metallisierung weist dabei eine Dicke von zumindest 300 µm auf. In weiteren bevorzugten Ausführungsformen weist die Metallisierung eine Dicke von zumindest 0,5 bzw. 1 mm, 2mm, 3mm oder 4mm auf. Die ersten metallischen Strukturen weisen dabei einen Leistungshalbleiter auf. Der Leistungshalbleiter ist in aller Regel auf die ersten Strukturen gefügt, z.B. gelötet oder gesintert. Die ersten Strukturen sind somit mit einem wärmeerzeugenden Bauteil versehen und weisen eine höhere Wärmebelastung auf als die zweiten Strukturen, die vorzugsweise keinen Leistungshalbleiter aufweisen. Als Leistungshalbleiter kommen im vorliegenden Fall schaltende und nichtschaltende Bauelemente wie beispielsweise IGBTs, MOSFETs, Dioden oder andere Halbleiterschalter mit großem Bandabstand infrage.

Weiterhin ist erfindungsgemäß bezüglich der Zwischenräume zumindest abschnittsweise ein elektrischer Isolator so angeordnet, dass die jeweils an den Zwischenraum angrenzenden Strukturen durch den Isolator thermisch verbunden sind. Der Isolator weist dabei eine Wärmeleitfähigkeit von zumindest 50 W/mK auf. Insbesondere weist der Isolator eine Wärmeleitfähigkeit von zumindest 100 W/mK, 200 W/mK oder 500 W/mK auf. Derartig hohe Wärmeleitfähigkeiten sorgen dafür, dass trotz vergleichsweise geringer Flächen eine hohe Wärmeabfuhr aus den ersten Strukturen ermöglicht wird. Das Ergebnis ist eine gleichmäßigere Verteilung der Wärme über die gesamte leistungselektronische Baugruppe. Als Werkstoffe können hier wärmeleitende Diamantwerkstoffe und bestimmte Keramiken (Si3N4 und AlN) verwendet werden.

Ein solches Substrat mit einer Metallisierung kann beispielsweise als ein Dickkupfersubstrat ausgebildet sein. Unter einem Dickkupfersubstrat (auch organisches DBC) ist ein Schaltungsträger zu verstehen, der ein Metall (Cu, Al, ...) mit einer Dicke von > 300 µm aufweist (üblicherweise 1 - 4 mm) und dessen Isolationsmaterial insbesondere aus einem Kunststoff oder Kunststoffverbundmaterial besteht. Ein Beispiel ist das organic direct copper bond (ODBC). Durch den Kunststoff können deutlich höhere thermo-mechanische Kräfte (z. B. durch einen CTE Mismatch) ausgeglichen werden und dementsprechend hohe Metallschichtdicken umgesetzt werden. Im Vergleich zu keramischen Substraten (DBC, AMB), wo die großen Metallisierungs- bzw. Kupferdicken zu einem schnelleren Versagen führen können (z. B. Muschelbruch der Keramik), hat sich Kunststoff als Substratmaterial bewährt.

Die Wärmeleitfähigkeit bezieht sich dabei, wenn nicht anders angegeben, auf die Wärmeleitfähigkeit des Isolators bei 20°C Umgebungstemperatur.

In einer weiteren Ausführungsform ist die Metallisierung höchstens 7 mm, insbesondere höchstens 4 mm dick. Weiterhin weisen die Zwischenräume eine Breite von zumindest 0,1 mm auf und höchstens 8 mm auf. Vorzugsweise weisen die Zwischenräume eine Breite von 0,3 und 5 mm auf.

In einer weiteren Ausführungsform ist der Isolator 50% der Höhe der Aussparungen auf. Die Höhe der Aussparungen entspricht der Höhe der Metallisierung. In weiteren Ausführungsformen kann der Isolator 80% -100% der Höhe der Aussparung ausfüllen. Es ist ebenso möglich, dass der Isolator aus der Aussparung etwas heraussteht. Betrachtet man die Aussparungen in der Ebene der Metallisierung, so kann der Isolator hier um einen möglichst guten Wärmeübergang zu ermöglichen vorzugsweise 50% der zwischen den beiden thermisch zu verbindenden Strukturen liegenden Aussparung abdecken.

In einer besonders bevorzugten Ausführungsform weisen die zweiten Strukturen keine Leistungshalbleiter auf. Derartige zweite Strukturen sind oftmals zur Kontaktierung der Leistungsanschlüsse ausgebildet und sind elektrisch zum Beispiel über Bond-Drähte mit den Oberseiten der verwendeten Leistungshalbleiter kontaktiert. Aus thermischer Sicht sind die zweiten Strukturen gering belastet und weisen daher ein erhebliches Entwärmungspotenzial auf. Somit ist es vorteilhaft möglich, die zweiten Strukturen in die Entwärmung der gesamten leistungselektronischen Baugruppe mit einzubeziehen.

In einer weiteren besonders bevorzugten Ausführungsform ist zumindest eine der ersten Strukturen mit zumindest einer der zweiten Strukturen durch den Isolator thermisch verbunden. Mit anderen Worten sind diejenigen Strukturen miteinander verbunden, die thermisch gesehen eine unterschiedliche Belastung aufweisen. Das heißt, die eher heißen bzw. warmen ersten Strukturen, die die Leistungshalbleiter aufweisen, werden mit den zweiten Strukturen verbunden, die wiederum keinen Leistungshalbleiter aufweisen. So ist die Temperaturverteilung auf der leistungselektronischen Baugruppe gleichmäßiger und die Wärmeabfuhr kann so verbessert werden und die vorhandene Fläche von Kühlkörpern besser genutzt werden.

In einer weiteren Ausführungsform weist die leistungselektronische Baugruppe einen Shunt auf, der mit einer der ersten Strukturen und einer der zweiten Strukturen elektrisch kontaktiert ist, die durch einen der Isolatoren thermisch miteinander verbunden sind. Dies hat den großen Vorteil, dass der Shunt, der an seinen beiden elektrischen Kontaktstellen idealerweise ein ähnliches Temperaturniveau aufweist, nun durch die thermische Kopplung über den Isolator eine besonders gleichmäßige Temperaturverteilung an seinen elektrischen Kontaktstellen aufweist. Dies ermöglicht eine erheblich genauere Strommessung durch den Shunt. Des Weiteren kann auf die Kompensation von Temperatureffekten bei der Strommessung verzichtet werden.

In einer weiteren Ausführungsform weist der Isolator Diamant auf. Diamanten sind als künstlich erzeugte Industriediamanten in industriellem Maßstab erhältlich und können inzwischen auch zu größeren Schichten hergestellt werden (CVD, PVD, ...). Diamant weist ein enorm hohes Wärmeleitungsvermögen von bis zu 2.000 W/mK bei sehr guten elektrischen Isolationseigenschaften auf und ist dementsprechend im vorliegenden Fall als Isolator sehr gut geeignet. Es können hierbei beispielsweise metallisierte Diamantplättchen zum Einsatz kommen. Es ist ebenso denkbar, z.B. für weniger anspruchsvolle Anforderungen einen diamantpulvergefüllten Isolator oder auch keramische Isolatoren(z.B. Si3N4, AlN, ...) bereitzustellen.

In einer weiteren Ausführungsform besteht der Isolator aus Diamant. Insbesondere für Anwendungen mit einem hohen Leistungsprofil und einer hohen Leistungsdichte ist ein aus Diamant bestehender Isolator, der eine gleichmäßige Wärmeverteilung über die elektrische Baugruppe ermöglicht, vorteilhaft.

In einer weiteren Ausführungsform ist der Isolator derart im Zwischenraum und/oder im Substrat angeordnet, dass der Isolator jeweils unmittelbar mit den thermisch verbundenen Strukturen in Kontakt steht. Es ist denkbar, dass dies nur einseitig mit einer der Strukturen oder beidseitig mit beiden Strukturen ausgeführt ist. Ein unmittelbarer Kontakt hat den Vorteil, dass kein weiteres Material eingebracht werden muss.

In einer weiteren Ausführungsform wird der Isolator über ein thermisch leitendes Polymer und/oder Harz mit den angrenzenden Strukturen thermisch verbunden. Derartige Polymere und/oder Harze können beispielsweise als Polyimid oder gefüllte Epoxidmaterialien ausgebildet sein. Als Füllpartikel bieten sich hier beispielsweise keramische Partikel wie Aluminiumnitride, Bornitride, Si3N4 und/oder Al2O3 an. Die Anbindung vom Isolator an die Strukturen kann als elektrisch nicht-isolierend (d.h. zumindest teilweise elektrisch leitend) ausgeführt sein, da die Isolation bereits durch den Isolator bereitgestellt wird. Metallische und auf Graphit basierende Füllstoffe sind also ebenfalls denkbar. Die Anbindung des Isolators über eine sehr dünne Schicht thermisch leitenden Polymers und/oder Harzes hat den großen Vorteil, dass gerade, wenn die thermische Belastung auf die Baugruppe eine wechselnde ist, der thermische Kontakt zwischen dem Isolator und den jeweils angrenzenden Strukturen den durch CTE Unterschiede entstehende Spannungen besser widersteht. Gerade im Hinblick auf die thermische Verformung der Baugruppe ist dies vorteilhaft.

In einer weiteren Ausführungsform weist der Isolator an seinen Enden eine voneinander elektrisch isolierte Metallisierung auf, z. B. zwei voneinander getrennte, metallisierte Flächen. Weiterhin ist der Isolator bezüglich der Strukturen oberseitig mit seiner Metallisierung an die Strukturen gefügt. Hier kommen insbesondere Löten oder Sintern in Frage.

In einer weiteren Ausführungsform ist die leistungselektronische Baugruppe als eine Halbbrücke ausgebildet. Die Halbbrücke weist dabei zumindest zwei als Halbleiterschalter ausgebildete Leistungshalbleiter auf. Die Leistungshalbleiter sind dabei jeweils auf einer ersten Struktur angeordnet, wobei die ersten Strukturen, auf denen die Leistungshalbleiterschalter angeordnet sind, jeweils mit einer zweiten Struktur thermisch über einen Isolator verbunden sind. So ist beispielsweise einer der Halbleiterschalter die High-Side und einer der Halbleiterschalter die Low-Side der Halbbrücke. Beide (High- und Low-Side) werden dabei thermisch mit den weniger beanspruchten zweiten Strukturen verbunden, was dazu führt, dass die entstehende Abwärme gleichmäßiger über die gesamte Baugruppe verteilt wird. Die gleichmäßigere Verteilung der Wärme über die Baugruppe kann dabei dazu führen, dass das Modul bzw. die Baugruppe eine höhere Leistung bereitstellen kann oder bei gleichbleibender Leistung kleinere Halbleiterschalter zum Einsatz kommen können. Die Halbbrücke ist dabei selbstverständlich erweiterbar auf eine Vollbrücke oder eine dreiphasige Konfiguration.

Die Aufgabe wird weiterhin durch ein Verfahren zum Herstellen eines Halbzeugs für die erfindungsgemäße Baugruppe gelöst. Dazu werden Halbzeuge für das Substrat, die Strukturen und die Isolatoren bereitgestellt. Bei derartigen Halbzeugen kann sich beispielsweise um Kupferfolien und Kunststoff-Prepregs handeln. Die Isolatoren können dabei beispielsweise als Diamantplättchen vorliegen. Die Halbzeuge werden dann beispielsweise übereinandergestapelt und die Isolatoren bereits an den Stellen angeordnet, die Zwischenräume bilden. Die Halbzeuge können im nächsten Schritt verpresst werden, sodass sich die Halbzeuge miteinander verbinden und sodass sich ein thermischer Kontakt zwischen den sich dann ausbildenden Strukturen und den Isolatoren ausbildet.

Im Folgenden wird die Erfindung anhand der in den Figuren dargestellten Ausführungsbeispiele näher beschrieben und erläutert. Es zeigen jeweils schematisch:
- FIG 1: eine Ausführungsform einer leistungselektronischen Baugruppe,
- FIG 2: einen Schnitt durch die leistungselektronische Baugruppe aus FIG 1,
- FIG 3: eine Alternative zum Querschnitt aus FIG 2
- FIG 4: eine Möglichkeit zur Herstellung des Substrats und
- FIG 5: eine weitere Möglichkeit zur Herstellung des Substrats.

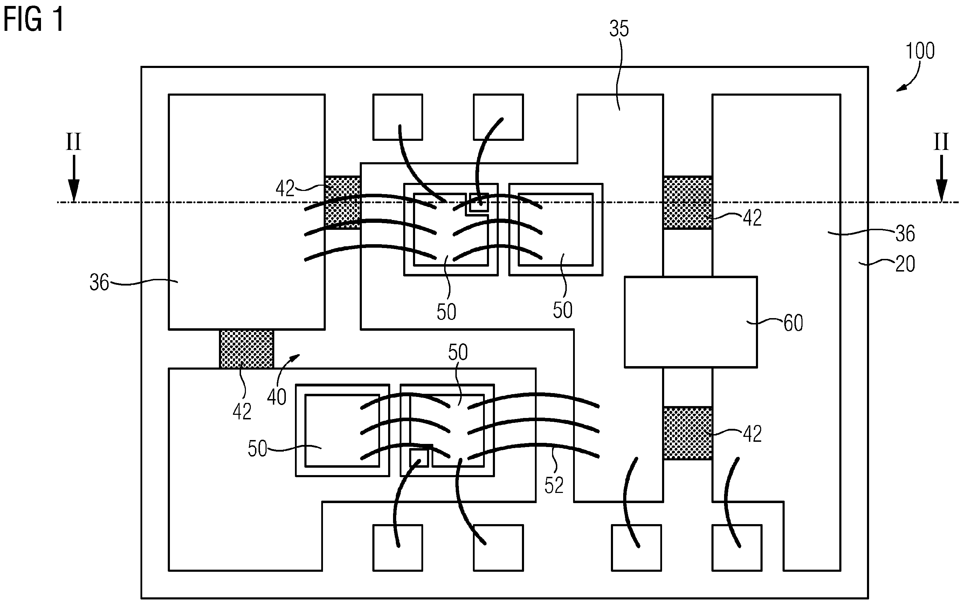

Figur 1 zeigt eine leistungselektronische Baugruppe 100 mit einem Substrat 20, auf dem eine Metallisierung 30 aufgebracht ist. Die Metallisierung 30 weist dabei erste Strukturen 35 und zweite Strukturen 36 auf. Die leistungselektronische Baugruppe 100 ist im vorliegenden Fall als eine leistungselektronische Schaltung in Form einer Halbbrücke mit IGBTs, Dioden und einem Shunt ausgebildet. Zu diesem Zweck weisen die ersten Strukturen 35 Leistungshalbleiter 50 auf. Diese Leistungshalbleiter 50 erzeugen Abwärme, die von den ersten Strukturen 35 weggeleitet werden muss. Um die Fläche zur Wärmeableitung zu vergrößern, wird vorliegend zu den zweiten Strukturen 36 eine thermische Verbindung vorgesehen, die durch einen elektrischen Isolator 42 mit einer hohen Wärmeleitfähigkeit ausgestaltet ist. Die gut wärmeleitfähigen Isolatoren 42 sind dabei so in Zwischenräumen 40 zwischen den ersten und den zweiten Strukturen 35, 36 angeordnet, dass ein thermischer Kontakt zwischen den warmen ersten Strukturen 35 und den kühleren zweiten Strukturen 36 entsteht. Auf die gesamte leistungselektronische Baugruppe 100 gesehen, erfolgt eine erheblich verbesserte Wärmespreizung, was die Abfuhr der Wärme erheblich vereinfacht. Die Leistungshalbleiter sind vorliegend mit Bonddrähten 52 kontaktiert, können aber ebenso mit anderen Kontaktierungsmitteln verbunden sein.

Im vorliegenden Beispiel weist die leistungselektronische Baugruppe einen Shunt 60 auf. Der Shunt 60 ist in diesem Fall so angeordnet, dass er zur Strommessung eine erste Struktur 35 mit einer der zweiten Strukturen 36 verbindet. Da zur Strommessung eine möglichst gleichmäßige Temperaturverteilung zwischen den beiden Kontakten des Shunts 60 notwendig ist, ist es besonders vorteilhaft, wenn der Shunt 60 auf ersten Strukturen 35 und zweiten Strukturen 36 so angeordnet ist, dass diese jeweils mit einem gut wärmeleitenden Isolator 42 verbunden sind. Dadurch wird die Temperaturdifferenz zwischen den warmen ersten Strukturen 35 und den zweiten Strukturen 36 deutlich verringert.

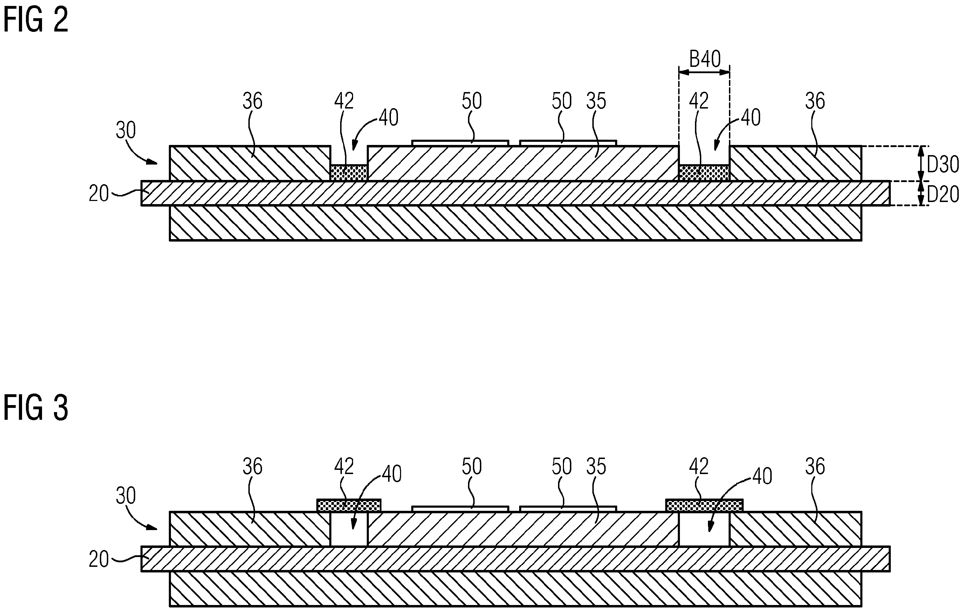

Figur 2 zeigt einen Schnitt durch die in der Figur 1 gezeigten leistungselektronischen Baugruppe 100. Die Bezugszeichen wurden dabei analog zur Figur 1 vergeben. Die Substratisolation 20 weist eine Dicke D20 von ca. 20µm-1000µm auf. Die Metallisierung 30 weist eine Dicke D30 von ca. 300 µm bis 4 mm auf. Die Zwischenräume 40 weisen eine Breite B40 von ca. 200µm bis 5 mm auf. Die erfindungsgemäßen Isolatoren 42 sind dabei so in den Zwischenräumen 40 angeordnet, dass die in der Mitte angeordnete erste Struktur 35, die wiederum zwei Leistungshalbleiter 50 aufweist, thermisch über die Isolatoren 42 mit den am Rand angeordneten zweiten Strukturen 36 verbunden ist. Dies führt zu einer erheblich gleichmäßigeren Wärmeverteilung in der leistungselektronischen Baugruppe.

Figur 3 zeigt den Querschnitt, wie er in Figur 2 gezeigt ist, wobei die Isolatoren 42 nicht in den Zwischenräumen 40 angeordnet sind, sondern diese brückenartig überspannen. Diese Anordnung kann beispielsweise mit metallisierten Isolatoren 42 (die Metallisierung befindet sich hier an den jeweiligen beiden Enden), die auf die Metallisierung 30 aufgelötet wird, vorgesehen werden. Auch so entsteht eine erheblich verbesserte thermische Spreizung.

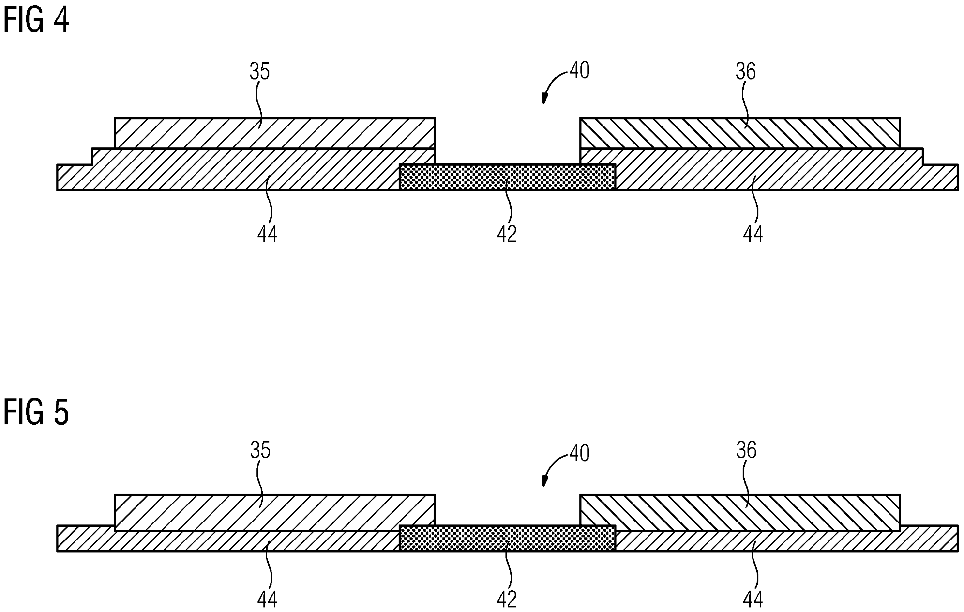

Figur 4 zeigt schematisch eine Möglichkeit, einen Isolator 42 bei der Herstellung gestapelt anzuordnen. Der Isolator 42 ist dabei von einem Isolationsmaterial 44, beispielsweise einem Polyimid oder einem gefüllten Epoxidmaterial, umgeben und berührt nicht unmittelbar die ersten Strukturen 35, 36 der Metallisierung 30. Beim Verpressen des Stapels, wie gezeigt, bildet sich ein sehr guter Wärmekontakt zwischen den Strukturen 35, 36 und dem Isolator 42. Das Isolationsmaterial 44 ist dabei ausreichend dünn, um den sehr guten Wärmeübergang zwischen den Strukturen 35, 36 nicht zu gefährden.

Figur 5 zeigt eine Alternative zu der in Figur 4 gezeigten Stapelstruktur. Die Strukturen 35, 36 sind hier unmittelbar mit dem Isolator 42 in Kontakt. Beim Verpressen ergibt sich auch hier ein guter thermischer Kontakt zwischen den Strukturen 35, 36 und dem Isolator 42.

Zusammenfassend betrifft die Erfindung eine leistungselektronische Baugruppe 100 und ein Verfahren zum Herstellen eines Halbzeugs für eine leistungselektronischen Baugruppe 100. Um eine verbesserte leistungselektronische Baugruppe 100 anzugeben wird vorgeschlagen, dass die Baugruppe 100, einer Substratisolation 20 mit einer Metallisierung 30, die durch Zwischenräume 40 voneinander getrennte erste und zweite Strukturen 35, 36 ausbildet und eine Dicke D30 von zumindest 300 µm aufweist, wobei auf die ersten Strukturen 35 ein Leistungshalbleiter 50 aufgebracht ist. Bezüglich der Zwischenräume 40 ist zumindest abschnittsweise ein elektrischer Isolator 42 mit einer Wärmeleitfähigkeit von zumindest 50 W/mK so angeordnet, dass die an den jeweiligen Zwischenraum 40 angrenzenden Strukturen 35, 36 durch den Isolator 42 thermisch verbunden sind.

### Bezugszeichen

- 100: Leistungselektronische Baugruppe
- 20: Substratisolation
- D20: Dicke der Substratisolation
- 30: Metallisierung
- D30: Dicke der Metallisierung
- 35: erste Strukturen der Metallisierung
- 36: zweite Strukturen der Metallisierung
- 40: Zwischenräume
- B40: Breite der Zwischenräume
- 42: Isolator
- 44: Isolationsmaterial
- 50: Leistungshalbleiter
- 52: Bonddraht
- 60: Shunt

## Patentansprüche

1. Leistungselektronische Baugruppe (100), umfassend ein Substrat (20) mit einer Metallisierung (30), die durch Zwischenräume (40) voneinander getrennte erste und zweite Strukturen (35, 36) ausbildet und eine Dicke (D30) von zumindest 300 µm, insbesondere von zumindest 1 mm oder 2 mm, aufweist, wobei auf die ersten Strukturen (35) ein Leistungshalbleiter (50) aufgebracht ist,
wobei bezüglich der Zwischenräume (40) zumindest abschnittsweise ein elektrischer Isolator (42) mit einer Wärmeleitfähigkeit von zumindest 50 W/mK so angeordnet ist, dass die an den jeweiligen Zwischenraum (40) angrenzenden Strukturen (35, 36) durch den Isolator (42) thermisch verbunden sind.

2. Leistungselektronische Baugruppe (100) nach Anspruch 1, wobei die Metallisierung (30) eine Dicke (D30) von höchstens 7 mm, insbesondere von höchstens 4 mm, aufweist.

3. Leistungselektronische Baugruppe (100) nach Anspruch 1 oder 2, wobei die Zwischenräume (40) eine Breite (B40) zwischen 0,1 mm und 8 mm, insbesondere zwischen 0,3 mm und 5 mm aufweisen.

4. Leistungselektronische Baugruppe (100) nach einem der vorhergehenden Ansprüche, wobei die zweiten Strukturen (36) keinen Leistungshalbleiter (50) aufweisen.

5. Leistungselektronische Baugruppe (100) nach einem der vorhergehenden Ansprüche, wobei zumindest eine der ersten Strukturen (35) und eine der zweiten Strukturen (36) durch einen der Isolatoren (42) thermisch verbunden sind.

6. Leistungselektronische Baugruppe (100) nach einem der vorhergehenden Ansprüche, ausweisend einen Shunt (60), der mit einer der ersten Strukturen (35) und einer der zweiten Strukturen (36) elektrisch kontaktiert ist, die durch einen der Isolatoren (42) thermisch verbunden sind.

7. Leistungselektronische Baugruppe (100) nach einem der vorhergehenden Ansprüche, wobei der Isolator (42) Diamant aufweist.

8. Leistungselektronische Baugruppe (100) nach einem der vorhergehenden Ansprüche, wobei der Isolator (42) aus Diamant besteht.

9. Leistungselektronische Baugruppe (100) nach einem der vorhergehenden Ansprüche,
wobei der Isolator (42) derart im Zwischenraum (40) und/oder im Substrat (20) angeordnet ist, dass der Isolator (40) jeweils unmittelbar mit den thermisch verbundenen Strukturen (35, 36) in Kontakt steht.

10. Leistungselektronische Baugruppe (100) nach einem der vorhergehenden Ansprüche,
wobei der Isolator (42) jeweils über ein thermisch leitendes Polymer und/oder Harz und/oder metallischen Verbindung (Lot, Sinterschicht, ...) mit den angrenzenden Strukturen (35, 36) thermisch verbundenen ist.

11. Leistungselektronische Baugruppe (100) nach einem der vorhergehenden Ansprüche, wobei der Isolator (42) an seinen Enden eine voneinander elektrisch isolierte Metallisierung aufweist und wobei der Isolator (42) oberseitig mit der Metallisierung an die Strukturen (35,36) gefügt ist.

12. Leistungselektronische Baugruppe (100) nach einem der vorhergehenden Ansprüche, die als eine Halbbrücke ausgebildet ist, aufweisend zumindest zwei als Halbleiterschalter ausgebildete Leistungshalbleiter (50), die jeweils auf einer ersten Struktur (35) angeordnet sind, wobei jede der ersten Strukturen (35) der Halbbrücke mit jeweils einer zweiten Struktur (36) thermisch über je einen Isolator (42) verbunden sind.

13. Verfahren zum Herstellen eines Halbzeugs für eine leistungselektronische Baugruppe (100) nach einem der vorhergehenden Ansprüche, umfassend die Schritte:
- Bereitstellen von Halbzeugen für das Substrat (20), die Strukturen (35,36) und die Isolatoren (42),
- Verpressen der Halbzeuge, sodass diese sich miteinander verbinden und sich ein thermischer Kontakt zwischen Strukturen (35,36) und den Isolatoren (42) ausbildet.
